# EUROPEAN PATENT SPECIFICATION

(11) **EP 0 858 725 B1**
(45) Date of publication and mention of the grant of the patent: **05.07.2000**
(21) Application number: 96935427.3
(22) Date of filing: 24.10.1996
(51) Int. Cl.: H05K 3/46

(54) **MULTILAYER PRINTED CIRCUIT BOARD AND PROCESS FOR PRODUCING THE SAME**
MEHRSCHICHTIGE GEDRUCKTE SCHALTUNGSPLATTE UND VERFAHREN ZU IHRER HERSTELLUNG
PLAQUETTE DE CIRCUIT IMPRIME MULTICOUCHE ET SON PROCEDE DE FABRICATION

(30) Priority: 31.10.1995 JP 28422595; 31.10.1995 JP 28422695; 09.11.1995 JP 29117095; 09.11.1995 JP 29117195; 09.08.1996 JP 21104296
(43) Date of publication of application: 19.08.1998
(73) Proprietor: Sumitomo Bakelite Company Limited, Shinagawa-ku, Tokyo 140 (JP)
(72) Inventor: HOSOMI, Takeshi, Fujieda-shi, Shizuoka 426 (JP); KISHI, Toyoaki, Fujieda-shi, Shizuoka 426 (JP); HONJOYA, Tomoyoshi, Fujieda-shi, Shizuoka 426 (JP); NAKAMICHI, Sei, Fujieda-shi, Shizuoka 426 (JP); MITSUI, Masahiro, Fujieda-shi, Shizuoka 426 (JP)
(74) Representative: Vossius, Volker, Dr.
(86) International application number: JP9603100
(87) International publication number: WO9716948

(56) References cited:
- PATENT ABSTRACTS OF JAPAN vol. 96, no. 1, 31 January 1996 & JP,A,07 245480 (SUMITOMO BAKELITE CO), 19 September 1995, cited in the application
- PATENT ABSTRACTS OF JAPAN vol. 95, no. 11, 26 December 1995 & JP,A,07 202418 (SUMITOMO BAKELITE CO), 4 August 1995, cited in the application
- PATENT ABSTRACTS OF JAPAN vol. 95, no. 10, 30 November 1995 & JP,A,07 170073 (TOAGOSEI CO), 4 July 1995,
- PATENT ABSTRACTS OF JAPAN vol. 96, no. 10, 31 October 1996 & JP,A,08 157566 (SUMITOMO BAKELITE CO), 18 June 1996, cited in the application
- PATENT ABSTRACTS OF JAPAN vol. 96, no. 8, 30 August 1996 & JP,A,08 111585 (SUMITOMO BAKELITE CO), 30 April 1996, cited in the application

## Description

This invention relates to a multilayer printed circuit board and a process for producing the same which use an internal layer circuit board coated with a light and heat curable undercoating agent, an insulating adhesive, and a copper foil and which utilize making the undercoating agent tack-free by irradiation with an active energy beam and heating to integrally cure them.

### Background Art

As to a multilayer printed circuit board, miniaturization and multifunctionalization have proceeded and the technique is shifted in the direction of making the density higher. That is to say, the technique is proceeding in the direction of making the circuit pattern finer, allowing a printed circuit board to have much more layers, making the diameter of via hole smaller and thinning the board or the like.

In the production of a multilayer printed circuit board, there has been used a process which comprises putting at least one sheet of a prepreg obtained by impregnating a glass cloth substrate with an epoxy resin and semi-curing the resin, on an internal layer circuit board on which a circuit has been formed, further putting a copper foil on the prepreg sheet and then molding the resulting assembly under heating by a hot plate press. However, in this process, the resin in the prepreg is allowed to flow again by heat and cured under a given pressure, and hence, a period of 1 to 1.5 hours is required for uniformly curing and molding the prepreg. Since the production process requires such a long period of time and in addition a hot plate press and a glass cloth prepreg are necessary, the production cost becomes high. Moreover, since a method of impregnating a glass cloth with a resin is carried out, it has been difficult to make the thickness between circuit layers smaller.

In recent years, for solving the above problems, attention has been paid again to a technique of preparing a multilayer printed circuit board by a build-up system in which neither the heat-pressure molding by a hot plate press nor the glass cloth as an insulator between circuit layers are used.

In the production of a multilayer printed circuit board by a build-up system, when as an insulator between circuit layers, the prepreg sheet obtained by impregnating a glass cloth with an epoxy resin and semi-curing the same is replaced with a copper-clad insulating sheet wherein an insulating resin layer is formed on the roughened surface of the copper foil, or with an insulating resin in the form of a film, the working efficiency is remarkably increased as compared with a method of forming an insulating layer between the circuit layers using a prepreg.
However, it is impossible to completely remove air present in the difference in level between insulating substrate and circuit in the internal layer circuit board, and hence, bubbles remain and cause bad insulation and deterioration of solder heat resistance, and furthermore, delamination is caused in some cases, which has become a problem. For preventing the problem, the lamination must be carried out under reduced pressure, and hence, a special equipment is required. Moreover, since the laminated insulating layer follows the difference in level between insulating substrate and circuit in the internal layer circuit board, there are such problems that no surface smoothness is obtained, soldering failure or the like is caused when a completed part is mounted, the peeling-off of a resist is caused in the course of forming an etching resist, a reduction of pattern-developing degree is caused, the stabilized resist formation is impossible, and the like.

Moreover, similarly to the case of using a prepreg, the amount of a resin filled is varied depending upon the percentage of the remaining copper foil of a circuit pattern in the internal layer circuit board, so that even when a copper-clad insulating sheet or a film-like insulating resin is used, the thicknesses of the multilayer printed circuit boards after molding do not become the same. That is to say, when the percentage of the remaining copper foil is large and the portions to be filled with the resin are a little, the board thickness becomes large, and when the percentage of the remaining copper foil is small and the portions to be filled with the resin are much, the board thickness becomes small, and hence, it is not possible to achieve the same board thickness unless the thickness of an insulating sheet or film is varied depending upon the percentage of the remaining copper foil. Furthermore, even in the case of a single internal layer circuit board, there is such a disadvantage that the thickness of a multilayer printed circuit board obtained does not become uniform when the percentage of the remaining copper foil varies with positions and this has been a problem to be solved.

In JP-A-7-202418 of the present inventors, an insulating adhesive similar to that of this invention is disclosed; however, an undercoating agent is not coated for filling the concaves between the circuits of an internal layer circuit board, and because of difference in level between the insulating substrate and the circuit of the internal layer circuit board, the surface smoothness becomes insufficient and many voids remain, so that the technique has been unable to be put to practical use.

After that, in the production of a multilayer printed circuit board by a build-up system, when a film-like insulating resin layer is used, the coating of an undercoating agent on the internal layer circuit board has been generalized for diminishing the difference in level between insulating substrate and circuit in the internal layer circuit board and increasing its surface smoothness. As a typical example thereof, there has been subjected to various studies a method which comprises laminating a copper foil coated with an insulating adhesive to an internal layer circuit board coated with an undercoating agent which has not been cured or has been semi-cured or cured, and curing the laminate to obtain a multilayer printed circuit board. By such a method, the difference in level between insulating substrate and circuit in an internal layer circuit board is diminished, and hence, there are obtained such merits that the lamination of a copper foil coated with an insulating adhesive is facilitated and the necessity to consider the percentage of the remaining copper foil in the internal layer circuit board becomes a little.

As such a technique, there is JP-A-7-245480 of the present inventors. However, since the undercoating agent coated on the internal layer circuit board does not contain any curing agent, when the insulating adhesive is laminated thereto and thereafter heated, no sufficient curing is obtained and hence this technique has been unable to be put to practical use. Furthermore, the present inventors have proposed in JP-A-8-111585 an insulating adhesive using a high molecular weight epoxy resin or phenoxy resin and a light and heat curable undercoating agent using an acrylate resin such as an epoxyacrylate or the like, and in JP-A-8-111586 a thermosetting type undercoating agent using an epoxy resin. Moreover, the present inventors have proposed in JP-A-8-157566 an undercoating agent using a bisphenol A type epoxy resin and a diluent consisting of a photopolymerizable monomer and dicyandiamide as a curing agent.

### Disclosure of Invention

This invention aims at providing a multilayer printed circuit board which is smaller in variation of thickness and higher in surface smoothness than a multilayer printed circuit board obtained by a system in which a prepreg as mentioned above is used and molding is effected using a hot plate press or by a conventional build-up system and which is suitable for high density mounting, and also providing a process for producing the multilayer printed circuit board.

According to this invention, there is provided a process for producing a multilayer printed circuit board which is defined by the features of claim 1. In particular, the process comprises coating a light and heat curable undercoating agent on an internal layer circuit board, irradiating the undercoating agent with an active energy beam (e.g., a light) to make the same tack-free, thereafter laminating thereto a copper foil coated with an insulating adhesive comprising as the main component a brominated bisphenol type epoxy resin or brominated phenoxy resin having a weight average molecular weight of at least 10,000 and then heating the resulting assembly to integrally cure the same.

### Brief Description of Drawings

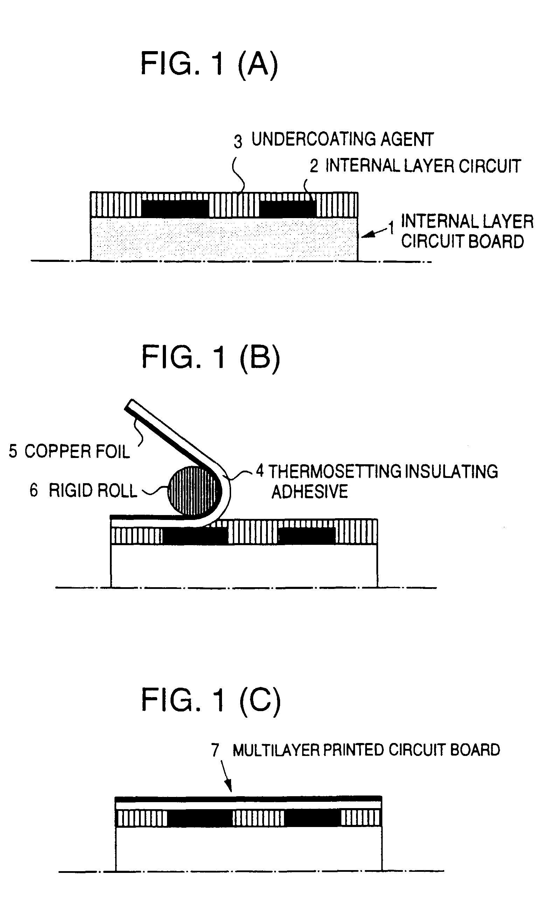

Fig. 1(A) to Fig. 1(C) are schematic sectional views explaining the process for producing a multilayer printed circuit board (an example) of this invention. In Fig. 1(A) to Fig. 1(C), 1 refers to an internal layer circuit board, 2 to an internal layer circuit, 3 to an undercoating agent, 4 to a thermosetting insulating adhesive, 5 to a copper foil, 6 to a rigid roll and 7 to a multilayer printed circuit board.

### Best Modes for Carrying Out the Invention

The undercoating agent used in an embodiment of this invention is preferably composed of:
(a) a normally solid epoxy resin having a softening point of not less than 45°C but not more than 120°C,
(b) an epoxy resin curing agent,
(c) a diluent in which the solid epoxy resin can be dissolved and which consists of a photopolymerizable monomer, and
(d) a photopolymerization initiator.

The thermosetting insulating adhesive used in the process of this invention comprises as the main component:
(e) a brominated bisphenol type epoxy resin or brominated phenoxy resin having a weight average molecular weight of at least 10,000, which is blended with
(f) a bisphenol type epoxy resin having an epoxy equivalent of not more than 500, and may further comprise
(g) an epoxy resin curing agent.

In the process of this invention, an internal layer circuit board is coated with a liquid, light and heat curable undercoating agent by means of a screen printing, a roller coater, a curtain coater or the like, to fill the concaves between the circuits in the internal layer circuit board, and the undercoating agent is irradiated with a light (active energy beam) such as ultraviolet ray or the like to be made tack-free. Thereafter, a copper foil provided with an uncured or semi-cured insulating adhesive is laminated to the internal layer circuit board coated with the undercoating agent by means of a heated roll or the like. After the lamination, the resulting laminate is heated to subject the light and heat curable undercoating agent and the copper foil provided with an insulating adhesive to integral curing reaction, whereby a multilayer printed circuit board can be prepared.

In the lamination, the undercoating agent is softened upon heating by a roll, and hence the thickness is averaged by the roll pressure, so that the copper foil surface can be smoothened. The insulating adhesive (coated on the copper foil) comprises as the main component an epoxy resin or phenoxy resin having a weight average molecular weight of at least 10,000, and it is laminated to the internal layer circuit board while the thickness of the insulating layer is maintained. Therefore, the thickness of the multilayer printed circuit board is uniformalized without depending upon the percentage of the remaining copper foil in the internal layer circuit, whereby a multilayer printed circuit board excellent in precision of board thickness can be produced.

In an embodiment of this invention, the undercoating agent is used to fill the concaves between the circuits in an internal layer circuit board and to smoothen the surface of the internal layer circuit, and is preferably composed of the following components (a) to (d):
(a) a normally solid epoxy resin having a softening point of not less than 45°C but not more than 120°C,
(b) an epoxy resin curing agent,
(c) a diluent in which the solid epoxy resin is dissolved and which consists of a photopolymerizable monomer, and
(d) a photopolymerization initiator.

More preferably, the normally solid epoxy resin (a) having a softening point of not less than 45°C but not more than 120°C is an epoxy resin comprising as the main component a brominated novolak type epoxy resin having a bromination degree of not less than 20% and a molecular weight of 500 to 4,000; the epoxy resin curing agent (b) is a high temperature-curable imidazole compound having a melting point of not less than 130°C; and the photopolymerizable and heat-reactive monomer (c) is at least one compound selected from the group consisting of glycidyl acrylate, glycidyl methacrylate, hydroxyethyl acrylate, hydroxyethyl methacrylate and triethylene glycol dimethacrylate.

Specifically, as an undercoating agent, there can be preferably used a composition consisting of:
(A) a brominated novolak type epoxy resin having a bromination degree of not less than 20% and a molecular weight of 500 to 4,000,
(B) a bisphenol type epoxy resin having a molecular weight of 500 to 2,000,
(C) a bisphenol type liquid epoxy resin having a molecular weight of not more than 500;
(D) a high temperature-curable imidazole compound having a melting point of not less than 130°C;
(E) a low temperature-curable imidazole compound;
(F) glycidyl acrylate or glycidyl methacrylate;
(G) hydroxyethyl acrylate, hydroxyethyl methacrylate or triethylene glycol dimethacrylate; and
(d) a photopolymerization initiator.

The brominated novolak type epoxy resin having a bromination degree of not less than 20% and a molecular weight of 500 to 4,000 [the component (A)] is used for enhancing the heat resistance and flame retardancy, and is a novolak type (such as phenol novolak type or cresol novolak type) epoxy resin and is normally solid. The softening point of the component (A), when used together with the components (B) and (C), may be within the range of 50°C to 150°C. When the bromination degree is less than 20%, the multilayer printed circuit board obtained hardly achieve V-0 of the nonflammability UL Standards in many cases. In this connection, the upper limit of the bromination degree corresponds to the case where all the brominatable positions of the benzene nuclei of the epoxy resin have been brominated, whereby the upper limit of bromination is determined.

The component (B) is a bisphenol type epoxy resin having a molecular weight of 500 to 2,000 and is used mainly for enhancing the flexibility and adhesiveness between the internal layer circuit board and the insulating adhesive, and the interaction with the component (A) and the component (C) affects the heat resistance, voidlessness and surface smoothness. When the molecular weight exceeds 2,000, the viscosity of the undercoating agent increases, the fluidity and ability to fill the concaves between internal layer circuits are deteriorated and the surface smoothness becomes bad, and hence, such a molecular weight is not desirable.

The component (C) is a bisphenol type liquid epoxy resin having a molecular weight of not more than 500 and is blended particularly for enhancing the ability to fill the concaves between internal layer circuits, the wettability to the internal layer circuit board, voidlessness and surface smoothness. When the molecular weight exceeds 500, these effects are diminished, and hence such a molecular weight is not desirable.

The photopolymerizable monomer (c) serves as a diluent for the epoxy resin, and a photopolymerizable monomer having a heat-sensitive functional group is preferably used as a part of the component (c). As the component (c), there can be used acrylate and methacrylate compounds having at least one hydroxyl group in one molecule such as hydroxyethyl acrylate, hydroxyethyl methacrylate, hydroxypropyl acrylate, hydroxypropyl methacrylate, hydroxybutyl acrylate, hydroxybutyl methacrylate, butanediol monoacrylate, glycerol methacrylate, phenoxyhydroxypropyl acrylate, polyethylene glycol acrylate, polyethylene glycol methacrylate, glycerol dimethacrylate and the like and, in addition, acrylate and methacrylate compounds having at least one glycidyl group in one molecule such as glycidyl acrylate, glycidyl methacrylate and the like. A light-sensitive polyfunctional monomer having a diluent effect can also be used.

The photopolymerizable monomer (c) is preferably the component (F) which is glycidyl acrylate or glycidyl methacrylate having a heat-sensitive functional group and an excellent heat-curability, or the component (G) which is hydroxyethyl acrylate, hydroxyethyl methacrylate or triethylene glycol dimethacrylate. These components serve as a solvent for the epoxy resin and are used for obtaining the so-called solventless type undercoating agent.

The components (F) and (G) react upon irradiation with a light and the polymerization thereof makes the undercoat layer tack-free. When the component (F) is heated, the glycidyl group thereof reacts with the curing agent whereby the component (F) is cured together with the epoxy resin, so that the heat resistance of the undercoating agent is increased and the generation of voids is inhibited. The proportion of each of these components blended is appropriately determined in the range of from 20% to 80% by weight based on the total weight of the two. The total amount of the components (F) and (G) is preferably 20 to 100 parts by weight, more preferably 30 to 70 parts by weight, per 100 parts by weight of a total of the epoxy resins.

The photopolymerization initiator (d) includes benzophenones such as benzophenone, benzoylbenzoic acid, 4-phenylbenzophenone, hydroxybenzophenone and the like; benzoin; benzoin alkyl ethers such as benzoin ethyl ether, benzoin isopropyl ether, benzoin butyl ether, benzoin isobutyl ether and the like; acetophenones such as 4-phenoxydichloroacetophenone, 4-t-butyl-dichloroacetophenone, 4-t-butyl-trichloro-acetophenone, diethoxyacetophenone, 2,2-dimethoxy-2-phenylacetophenone and the like; thioxanthones such as thioxanthone, 2-chlorothioxanthone, 2-methylthioxanthone, 2,4-dimethylthioxanthone and the like; alkylanthraquinones such as ethylanthraquinone, butylanthraquinone and the like; etc. These may be used alone or in admixture of two or more. The amount of the photopolymerization initiator (d) added is preferably 0.1 to 10 parts by weight per 100 parts by weight of the photopolymerizable and heat-reactive monomer.

As the epoxy resin curing agent (b), the component (D) is preferably used.

The high temperature-curable imidazole compound (D) has a melting point of not less than 130°C, is small in solubility in the epoxy resin and rapidly reacts with the epoxy resin at a high temperature not lower than about 150°C, and is added for finally curing the epoxy resin. The component (D) includes specifically 2-methylimidazole, 2-phenylimidazole, 2-phenyl-4-methylimidazole, bis(2-ethyl-4-methylimidazole), 2-phenyl-4-methyl-5-hydroxymethylimidazole, 2-phenyl-4,5-dihydroxymethylimidazole, triazine-addition type imidazole and the like. Epoxy adducts of them and microcapsules of them can also be used. These may be used alone or in combination of two or more.

More preferably, the component (E) is used together with the component (D). The low temperature-curable imidazole compound (E) is well soluble in the epoxy resin and reacts with the epoxy resin at a relatively low temperature range of from 60°C to 120°C. This curing agent is used for allowing the epoxy resin to start the reaction at the initial stage of heating. When the undercoating agent and the insulating adhesive are integrally cured, it becomes important for molding that the curing reaction starts from the undercoating agent side. Specific examples used as the component (E) include imidazole, 2-ethyl-4-methylimidazole, 2-undecylimidazole, 1-cyanoethyl-2-methylimidazole, 1-cyanoethyl-2-phenylimidazole, 1-cyanoethyl-2-ethyl-4-methylimidazole, 1-aminoethyl-2-methylimidazole, 1-(cyanoethylaminoethyl)-2-methylimidazole, 1-cyanoethyl-2-phenyl-4,5-bis(cyanoethoxymethyl)imidazole and the like. Epoxy adducts of them and microcapsules of them can also be used. These may be used alone or in combination of two or more.

In this case, the amount of the epoxy resin curing agent is varied depending upon the kind of the imidazole compound, and the total amount of the component (D) and the component (E) is 1 to 10 parts by weight per 100 parts by weight of the epoxy resin, and the proportion of the component (E) is appropriately determined depending upon the reaction starting temperature and melt viscosity of the undercoating agent.

In addition, the light and heat curable undercoating agent may, if necessary for storage stability, have added thereto an ultraviolet inhibitor, a heat-polymerization inhibitor, a plasticizer or the like. Also, for adjusting the viscosity, there can be added an acrylate monomer, a methacrylate monomer, a vinyl monomer or the like. Moreover, there can be incorporated an inorganic filler such as molten silica, crystalline silica, calcium carbonate, aluminum hydroxide, alumina, barium sulfate, mica, talc, clay, white carbon, E glass powder or the like, and there can be added an epoxysilane coupling agent for improving the adhesiveness to the copper foil and internal layer circuit board and the moisture resistance, a defoaming agent for preventing voids or a liquid or powdery flame retardant, or the like.

The light and heat-curable undercoating agent comprising the above-mentioned components is a substantially solventless system but can fill the concaves between circuits in an internal layer circuit board to smoothen the internal layer circuit surface. Moreover, the undercoating agent is easily solidified upon irradiation with a light to be made tack-free.

The component (c) in the formulated undercoating agent acts first of all as a solvent to dissolve the component (a) and other components to convert the undercoating agent to a varnish. Accordingly, the undercoating agent fills the concaves between the circuits in the internal layer circuit board to smoothen the internal layer circuit surface. The component (c) acting as the solvent is polymerized upon irradiation with a light to become solid and accordingly looses its action and hence deposits the component (a). Then, the polymerized component (c) and other components are dispersed in the solid component (a). Accordingly, the undercoating agent used in this invention is made tack-free upon irradiation with a light when the component (a) is selected so that the component (a) alone is in an appropriate tack-free state at ordinary temperature. Such a mechanism of making the undercoating agent tack-free is one of the most important characteristics of this invention.

Furthermore, the component (c) polymerized by irradiation with a light has a heat-reactive functional group too, and hence is reacted with the curing agent to be cured similarly to the main component epoxy resin during the subsequent heating. Therefore, the cured undercoating agent is excellent in heat resistance, chemical resistance and the like.

By co-using, as the photopolymerizable monomer, a compound having at least one acryloyl or methacryloyl group and at least one glycidyl group in one molecule and a compound having at least one acryloyl or methacryloyl group and at least one hydroxyl group in one molecule in the above-mentioned manner, the undercoating agent is well made tack-free upon irradiation with a light and the integral curing after the lamination to a copper foil provided with an insulating adhesive is well conducted, whereby a multilayer printed circuit board which is free from voids and excellent in surface smoothness and has good characteristics can be prepared.

The insulating adhesive used in this invention is preferably composed of:
(e) a brominated bisphenol type epoxy resin or brominated phenoxy resin having a weight average molecular weight of at least 10,000,
(f) a bisphenol type epoxy resin having an epoxy equivalent of not more than 500, and
(g) an epoxy resin curing agent,
and has good adhesiveness, heat resistance and flame resistance.

In this invention, the brominated bisphenol type epoxy resin or brominated phenoxy resin (e) having a weight average molecular weight of at least 10,000 is blended for the purpose of diminishing the degree of softening of the resin during molding, keeping the thickness of an insulating layer and imparting a flexibility to the composition obtained. Said epoxy resin includes brominated bisphenol A type epoxy resins, brominated bisphenol F type epoxy resins and the like.

In addition to the above purposes, for imparting a sufficient flame retardancy to the composition, a brominated bisphenol type epoxy resin or brominated phenoxy resin having a bromination degree of 20% or more is preferred. When the bromination degree is less than 20%, the multilayer printed circuit board obtained cannot achieve V-0 of the nonflammability UL Standards. Moreover, for enhancing the dissolution in other resins, solvents or the like, a brominated epoxy resin or brominated phenoxy resin having a repeating structure in which brominated bisphenol portion and unbrominated bisphenol portion are alternately arranged is preferred.

When the above brominated high molecular weight epoxy or phenoxy resin is used alone, the adhesive is poor in fitness and adhesiveness during laminating, insufficient in adhesiveness after lamination and too low in cross-linking density after curing to ensure heat resistance; and when the resin is dissolved in a solvent to form a varnish for coating a copper foil the viscosity thereof is so high that the fitness and workability during coating are not desirable. In order to overcome these drawbacks, the bisphenol type epoxy resin (f) having an epoxy equivalent of not more than 500 is blended.

The proportion of this high molecular weight epoxy or phenoxy resin (e) is preferably 55 to 90% by weight based on the total weight of the two resins (accordingly, the proportion of the component (f) blended based on the total weight of the two resins is preferably 10 to 45% by weight). When the proportion of the component (e) is less than 55% by weight, the resin is so much softened by heating during lamination that it becomes difficult to ensure the insulation film thickness between circuit layers. In addition, there are in some cases caused such problems that the melt viscosity is so much lowered during heat-curing that wrinkle is formed on the copper foil. On the other hand, when the proportion is more than 90% by weight, the adhesive before curing is hard and lacks elasticity, so that the property of following-up the irregularities of the internal layer circuit board during laminating and the adhesiveness are inferior and molding voids are caused.

The epoxy resin (f) includes bisphenol A type epoxy resins, bisphenol F type epoxy resins and the like which have an epoxy equivalent of not more than 500. When brominated products thereof are used, a flame retardancy is more effectively imparted to the multilayer printed circuit board. More specifically, those having an epoxy equivalent of about 200 and those having an epoxy equivalent of about 450 are used alone or in combination taking into consideration the workability in coating a copper foil.

The epoxy resin curing agent (g) includes amine compounds, imidazole compounds, acid anhydrides and the like and are not particularly limited. However, the imidazole compounds are preferred because they can sufficiently cure the epoxy resin even when used in a small amount and moreover enable the brominated epoxy resin to effectively exert its flame-retardancy. As the imidazole compounds, it is preferable to use those of the same kind as the component (D) used in the undercoating agent. That is, as the imidazole compounds, there are particularly preferable those which are normally solid, have a melting point of not less than 130°C, are low in solubility in epoxy resins and rapidly react with the epoxy resin when the temperature reaches a high temperature of not less than 150°C.

Specifically, they include 2-methylimidazole, 2-phenylimidazole, 2-phenyl-4-methylimidazole, bis(2-ethyl-4-methylimidazole), 2-phenyl-4-methyl-5-hydroxymethylimidazole, 2-phenyl-4,5-dihydroxymethylimidazole, triazine-addition type imidazole and the like. These imidazoles are uniformly dispersed in the form of fine powders in an epoxy resin varnish. In addition, since they are low in compatibility with the epoxy resin, no reaction proceeds at a temperature of room temperature to 100°C, and hence, storage stability can be maintained well. When they are heated to not less than 150°C in the curing of the laminate, they can react with the epoxy resin to prepare a uniform cured product.

As another curing agent, there can be used acid anhydrides such as phthalic anhydride, tetrahydrophthalic anhydride, methyltetrahydrophthalic anhydride, methylendomethylene tetrahydrophthalic anhydride, methylbutenyltetrahydrophthalic anhydride, hexahydrophthatlic anhydride, methylhexahydrophthalic anhydride, trimellitic anhydride, pyromellitic anhydride, benzophenonetetracarboxylic anhydride and the like; amine complex of boron trifluoride; dicyandiamide; derivatives of dicyandiamide; and the like. Epoxy adducts of the above compounds and microcapsules of the above compounds can also be used.

The acid anhydride curing agents are preferred because the amount of heat generated during the reaction is small. Among them, liquid acid anhydrides such as methyltetrahydrophthalic anhydride, methylendomethylene tetrahydrophthalic anhydride, methylbutenyltetrahydrophthalic anhydride, hexahydrophthalic anhydride, methylhexahydrophthalic anhydride and the like are more preferably used because they are easy to handle and contribute to the property of following-up the irregularities of internal layer circuit board and the adhesiveness during the laminate-molding.

In addition to the above epoxy resins and curing agent, the insulating adhesive can have compounded therewith components which can react with the epoxy resins and curing agent. Said components include, for example, reactive epoxy diluents (including phenyl glycidyl ether and the like as a monofunctional type; resorcin diglycidyl ether, ethylene glycol glycidyl ether and the like as a difunctional type; glycerol triglycidyl ether and the like as a trifunctional type); resole type or novolak type phenol resins; isocyanate compounds; and the like.

In addition to the above-mentioned components, molten silica, crystalline silica, calcium carbonate, aluminum hydroxide, alumina, clay, barium sulfate, mica, talc, white carbon, E glass fine powder and the like can be blended in a proportion of not more than 40% by weight of the resin content in order to enhance the linear expansion coefficient, heat resistance, flame resistance and the like of the adhesive. When the proportion is more than 40% by weight, the viscosity of the adhesive becomes high and the adhesiveness to the internal layer circuit board and the ability to fill concaves between the internal layer circuits become deteriorated.

Furthermore, there can be added a silane coupling agent such as an epoxy silane or the like or a titanate type coupling agent for enhancing the adhesiveness to a copper foil and an internal layer circuit board and improving the humidity resistance, a defoaming agent for preventing voids from being formed or a flame retardant in the form of a liquid or fine powders.

As the solvent, there must be selected those which do not remain in the adhesive after the adhesive coated on a copper foil has been dried at 80-130°C. For example, acetone, methyl ethyl ketone, toluene, xylene, n-hexane, methanol, ethanol, methyl Cellosolve, ethyl Cellosolve, cyclohexanone and the like can be used.

The insulating adhesive is usually coated on a copper foil and then used in this state; specifically, it is prepared by coating an adhesive varnish in which the adhesive components are dissolved in a given solvent on the roughened surface of a copper foil and thereafter drying the adhesive varnish at 80-130°C so that the solvent does not remain in the adhesive. The thickness of the adhesive layer is preferably 15-120 µm. When the thickness is less than 15 µm, the insulating properties between the circuit layers become insufficient in some cases, and when the thickness is more than 120 µm, the coating is not easy though the insulating properties between the circuit layers have no problem, and such a large thickness does not meet the purpose of this invention, that is, the thinning of the multilayer printed circuit board.

By using as the main component of the insulating adhesive a brominated epoxy resin or brominated phenoxy resin having a weight average molecular weight of at least 10,000, the copper foil provided with the insulating adhesive is laminated to the internal layer circuit board coated with the undercoating agent while the thickness of the insulating adhesive layer is maintained, so that it becomes possible to produce a multilayer printed circuit board having an excellent thickness precision without depending upon the percentage of the remaining copper foil in the internal layer circuit and without variation in thickness of the multilayer printed circuit board. However, this cannot be realized unless the undercoating agent coated on the internal layer circuit board is softened or fluidized by heating of a heated roll and the thickness is averaged by a roll pressure when the copper foil provided with the insulating adhesive is laminated. Moreover, the softening or fluidizing of the undercoating agent affects greatly the enhancement of adhesiveness to the insulating adhesive. That is to say, at the interface therebetween, they are dissolved in each other and curing reaction is caused, so that it comes to participate in the reliability of insulating characteristics between the circuit layers and the like.

However, during the heat-curing, the curing reaction of the undercoating agent is later than the curing reaction of the insulating adhesive, and when the melt viscosity is unnecessarily lowered the curing of the undercoating agent is affected by the cure-shrinkage of the insulating adhesive or the like, and faults such as formation of wrinkles and voids and the like are caused in some cases. On the other hand, when the undercoating agent used in this invention contains the component (E), the reaction at a low temperature region is accelerated and the unnecessary reduction of the melt-viscosity can be inhibited during heating, so that even when heat-curing after lamination is effected under substantially no pressure, a good smoothness, adhesiveness between layers and the like can be achieved.

The outline of the process for producing a multilayer printed circuit board of this invention, namely a process which comprises coating an undercoating agent on an internal layer circuit board and laminating thereto a copper foil provided with an insulating adhesive and curing the resulting assembly is explained below referring to Fig. 1(A) to Fig. 1(C). Fig. 1(A): A liquid undercoating agent (3) is coated on an internal circuit board (1) by a screen printing or using a conventional coating means such as a roller coater, a curtain coater or the like in such a thickness that one surface of the internal layer circuit board (1) is completely covered with the undercoating agent (3). When the amount coated is insufficient, it follows that air is caught up during the subsequent lamination. Thereafter, the undercoating agent is made tack-free by irradiation with a light. Subsequently, the other surface of the internal layer circuit board (1) is coated with an undercoating agent (3) in the same manner [this step is omitted in Fig. 1(A)]. Fig. 1(B): A copper foil (5) provided with a thermosetting insulating adhesive (4) is laminated to the surface of the tack-free undercoat layer coated on the internal layer circuit board. As a laminator, for example, a pair of rigid rolls (6) covered with a silicone rubber are used for achieving surface smoothness and the copper foils with insulating adhesive are laminated to both surfaces of the internal layer circuit board (1). The laminating conditions are varied depending upon the pattern of the internal layer circuit (2); however, the lamination is usually conducted at a pressure of about 0.5 to 6 kgf/cm² at a surface temperature of from room temperature to about 100°C at a laminating speed of about 0.1 to 6 m/min. Under such conditions, the photopolymerized and tack-free undercoating agent makes it possible to achieve the desired surface smoothness by using the rigid roll (6). In this case, the thickness of a layer between the internal layer circuit (2) and the copper foil (5) can be substantially achieved by the thickness of the insulating adhesive (4).
Fig. 1(C): Subsequently, the undercoating agent (3) and the thermosetting insulating adhesive (4) coated on the copper foil are simultaneously integrally cured by heating to prepare a multilayer printed circuit board.

Examples are shown below to explain this invention in more detail. However, the Examples are merely by way of illustration and not by way of limitation. In the Examples, parts are by weight unless otherwise specified.

### Example 1

In 170 parts of methyl ethyl ketone (MEK) were dissolved 100 parts of a brominated phenoxy resin (bromination degree: 25%, weight average molecular weight: 30,000) and 70 parts of a bisphenol F type epoxy resin (epoxy equivalent: 175, molecular weight: 380) with stirring, and thereto were added 4 parts of 2-phenyl-4-methylimidazole as a curing agent and 20 parts of a silane coupling agent (A-187 produced by Nippon Unicar Co., Ltd.) to prepare an insulating adhesive varnish. This varnish was coated on the roughened surface of a copper foil having a thickness of 18 µm so that the thickness after drying became 40 µm, by means of a roller coater, and dried to prepare an insulating adhesive-coated copper foil.

Separately, 100 parts of a brominated cresol novolak epoxy resin (bromination degree: 35%, epoxy equivalent: 280, weight average molecular weight: 1,400), 100 parts of a bisphenol A type epoxy resin (epoxy equivalent: 950, weight average molecular weight: 1,600) and 40 parts of a bisphenol F type epoxy resin (epoxy equivalent: 175, molecular weight: 380) were dissolved in 50 parts of glycidyl methacrylate and 70 parts of hydroxyethyl methacrylate, and to the solution were added 4 parts of 2-phenyl-4-methylimidazole and 8 parts of 1-cyanoethyl-2-ethyl-4-methylimidazole as curing agents and 10 parts of a photopolymerization initiator (Irgacure 651, a trade name of Ciba Geigy for 2,2-dimethoxy-2-phenylacetophenone), and they were mixed thoroughly in a homomixer to prepare an undercoating agent.

A flame-retardant type, glass epoxy double-side copper-clad laminate having a substrate thickness of 0.2 mm and a copper foil thickness of 35 µm was subjected to pattern processing to obtain an internal layer circuit board. The surface of the copper foil was subjected to black oxide treatment, and then the above-mentioned undercoating agent was coated on one surface of the internal layer circuit board in a thickness of about 25 µm by a screen printing. Subsequently, the resulting internal layer circuit board was irradiated with active energy beams under the condition of about 2 J/cm² using two high pressure mercury vapor lamps of 80 W/cm to make the undercoat layer tack-free. Thereafter, the same undercoat layer was prepared also on the other surface of the internal layer circuit board. Subsequently, in the same manner, an undercoat layer was prepared on the other side of the internal layer circuit board. Thereafter, the above-mentioned insulating adhesive-coated copper foils were laminated to the undercoat layers under the conditions of a temperature of 100°C, a pressure of 2 kg/cm² and a lamination speed of 0.8 m/min using a twin roll, and then the resulting assembly was heat-cured at 150°C for 30 minutes to prepare a multilayer printed circuit board.

### Examples 2 to 6

The same procedure as in Example 1 was repeated, except that as the curing agent for epoxy resin in the undercoating agent and the insulating adhesive, the 2-phenyl-4-methylimidazole was replaced with 2-methylimidazole (Example 2), 2-phenylimidazole (Example 3), bis(2-ethyl-4-methylimidazole) (Example 4), 2-phenyl-4-methyl-5-hydroxymethylimidazole (Example 5) or 2-phenyl-4,5-dihydroxymethylimidazole (Example 6), to prepare multilayer printed circuit boards.

### Example 7

The same procedure as in Example 1 was repeated, except that as the curing agent for epoxy resin in the undercoating agent, 10 parts of 2-phenyl-4-methylimidazole was used alone in place of 4 parts of 2-phenyl-4-methylimidazole and 8 parts of 1-cyanoethyl-2-ethyl-4-methylimidazole, to prepare a multilayer printed circuit board.

### Example 8

The same procedure as in Example 1 was repeated, except that in the undercoating agent, 120 parts of glycidyl methacrylate was used in place of the glycidyl methacrylate and the hydroxyethyl methacrylate, to prepare a multilayer printed circuit board.

### Example 9

The same procedure as in Example 1 was repeated, except that in the undercoating agent, 120 parts of hydroxyethyl methacrylate was used in place of the glycidyl methacrylate and the hydroxyethyl methacrylate, to prepare a multilayer printed circuit board.

### Example 10

In methyl ethyl ketone were dissolved 100 parts of a brominated phenoxy resin (bromination degree: 25%, epoxy equivalent: 6,400, weight average molecular weight: 30,000) and 35 parts of a bisphenol F type epoxy resin (epoxy equivalent: 175, molecular weight: 380), and to the solution were added 35 parts of methyltetrahydrophthalic anhydride and 0.5 part of 2-phenyl-4-methyl-5-hydroxymethylimidazole as a curing accelerator, 0.2 part of a titanate type coupling agent (KR-46B, a trade name of Ajinomoto Co., Inc.) and 20 parts of barium sulfate to prepare an adhesive varnish. Using this adhesive varnish, a multilayer printed circuit board was prepared in the same manner as in Example 1.

### Example 11

The same procedure as in Example 10 was repeated, except that the methyltetrahydrophthalic anhydride was replaced with methylendomethylene tetrahydrophthalic anhydride, to prepare a multilayer printed circuit board.

### Comparative Example 1

In the same manner as in Example 1, except that in the undercoating agent, 100 parts of diethylene glycol monoethyl ether was substituted for the glycidyl methacrylate and the hydroxyethyl methacrylate, and the undercoat layer was dried and precured by heating at 150°C in 20 minutes without effecting the irradiation with active energy beams, a multilayer printed circuit board was prepared.

### Comparative Example 2

In the same manner as in Example 1, except that the undercoating agent was not coated, a multilayer printed circuit board was prepared.

The multilayer printed circuit boards obtained were subjected to the following tests to obtain the characteristics shown in Table 1.

### Test method

1. Surface smoothness: R (max) was measured according to JIS B 0601.
2. Test of solder heat resistance after moistened:
   Moisture absorption conditions: Pressure cooker treatment at 125°C at 2.3 atms for 30 minutes.
   Test conditions: Test pieces were floated on a solder bath at 280°C for 120 seconds. The case where n = 5 and all test pieces were not blistered under said conditions was indicated as "o", the case where 1 to 4 test pieces were blistered was indicated as "Δ" and the case where all test pieces were blistered was indicated as "x".
3. Filling property: The outer layer copper foil was peeled off and then the ability of the resin material to fill the concaves between internal layer circuits was judged visually through an optical microscope. The case where the concaves were completely filled was indicated as "o", the case where the concaves were insufficiently filled was indicated as "Δ", and the case where filling was incomplete and voids were present was indicated as "x".
4. Insulating layer thickness between circuit layers: The multilayer printed circuit board was cut and the cross-section was observed through an optical microscope to determine the thickness of insulating layer between the internal layer circuit and the surface copper foil.
5. Voids residue: The whole of the copper foil surface of the multilayer printed circuit board was etched and the presence or absence of voids was determined visually.
   The case where no void remained was indicated as "o", the case where voids remained slightly was indicated as "Δ" and the case where voids were completely confirmed was indicated as "x".
6. Flame retardancy: According to UL Standards 94.

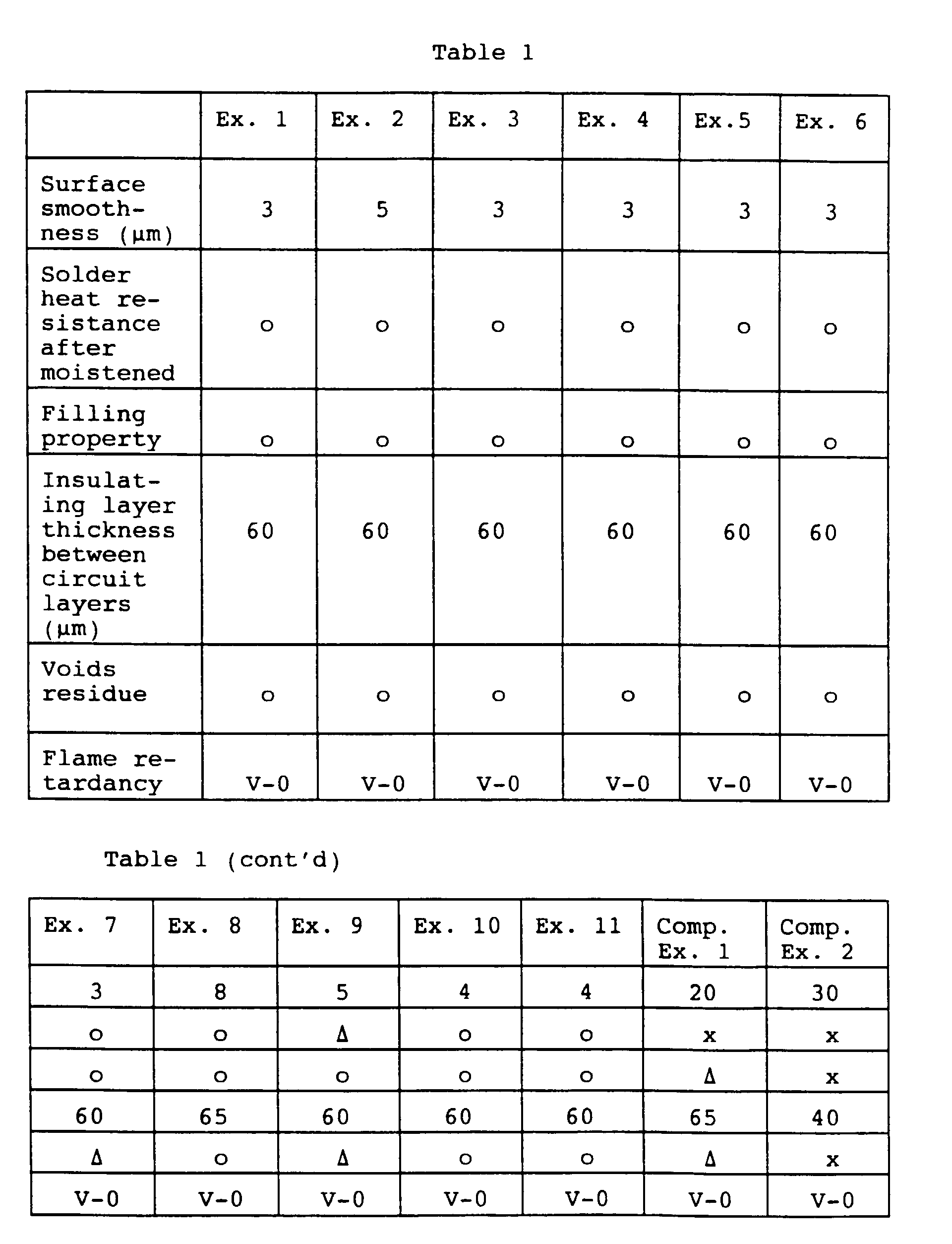

### Industrial Applicability

The multilayer printed circuit board of this invention is good in heat resistance and adhesiveness between circuit layers, and by using a brominated epoxy resin or brominated phenoxy resin, excellent flame resistance and excellent surface smoothness are imparted to the multilayer printed circuit board.

According to this invention, by coating an undercoating agent on an internal layer circuit board, irradiating the undercoating agent with a light to make it tack-free, and laminating thereto a copper foil provided with a thermosetting type insulating adhesive by a rigid roll or the like, the undercoating agent is softened or fluidized to smoothen the surface. Thereafter, the laminate is heated to integrally cure the undercoating agent coated on the internal layer circuit board and the insulating adhesive coated on the copper foil. Since the insulating adhesive coated on the copper foil keeps the thickness, a multilayer printed circuit board having an excellent thickness precision can be produced without depending on the percentage of the remaining copper foil in the internal layer circuit.

Thus, according to this invention, the production of a multilayer printed circuit board by a build-up method is made very easy.

## Claims

1. A process for producing a multilayer printed circuit board (7), comprising coating a light and heat curable undercoating agent (3), said undercoating agent comprising a diluent in which an epoxy resin is dissolved and which diluent consists of a photopolymerizable monomer, on an internal layer circuit board (1), irradiating the undercoating agent (3) with light to make the same tack-free, laminating to the tack-free undercoating a copper-foil (5) coated with a thermosetting insulating adhesive (4) comprising as the main component a brominated bisphenol type epoxy resin or a brominated phenoxy resin, both having a weight average molecular weight of at least 10 000, which is blended with a bisphenol type epoxy resin having an epoxy equivalent of not more than 500, and then heating the resulting assembly to integrally cure the assembly.

2. The process according to claim 1, wherein the undercoating agent comprises as essential components the following components (a), (b), (c) and (d):
(a) a normally solid epoxy resin having a softening point of not less than 45°C but not more than 120°C,
(b) an epoxy resin curing agent,
(c) a diluent in which the epoxy resin is dissolved and which consists of a photopolymerizable monomer, and
(d) a photopolymerization initiator.

3. The process according to Claim 2, wherein the component (a) is an epoxy resin comprising as the main component a brominated novolak type epoxy resin having a bromination degree of not less than 20% and a molecular weight of 500 to 4,000.

4. The process according to Claim 2, wherein the component (a) is a mixture of a brominated novolak type epoxy resin having a bromination degree of not less than 20% and a molecular weight of 500 to 4,000, a bisphenol type epoxy resin having a molecular weight of 500 to 2,000 and a bisphenol type liquid epoxy resin having a molecular weight of not more than 500.

5. The process according to Claim 2, wherein the component (b) is an imidazole compound curable at a high temperature not lower than about 150°C and having a melting point of not less than 130°C.

6. The process according to Claim 5, wherein the imidazole compound is selected from the group consisting of 2-methylimidazole, 2-phenylimidazole, 2-phenyl-4-methylimidazole, bis(2-ethyl-4-methylimidazole), 2-phenyl-4-methyl-5-hydroxymethylimidazole, 2-phenyl-4,5-dihydroxymethylimidazole, and triazine-addition type imidazole.

7. The process according to Claim 2, wherein the component (b) is a mixture of an imidazole compound curable at a high temperature not lower than about 150°C and having a melting point of not less than 130°C, and an imidazole compound curable at a relatively low temperature range of from 60°C to 120°C.

8. The process according to Claim 7, wherein the low temperature-curable imidazole compound is selected from the group consisting of imidazole, 2-ethyl-4-methylimidazole, 2-undecylimidazole, 1-cyanoethyl-2-methylimidazole, 1-cyanoethyl-2-phenylimidazole, 1-cyanoethyl-2-ethyl-4-methylimidazole, 1-aminoethyl-2-methylimidazole, 1-(cyanoethylaminoethyl)-2-methylimidazole, and 1-cyanoethyl-2-phenyl-4,5-bis(cyanoethoxymethyl)imidazole.

9. The process according to Claim 2, wherein the component (c) is at least one member selected from the group consisting of glycidyl acrylate, glycidyl methacrylate, hydroxyethyl acrylate, hydroxyethyl methacrylate and triethylene glycol dimethacrylate.

10. The process according to Claim 2, wherein the undercoating agent comprises as component (a)
a brominated novolak type epoxy resin (A) having a bromination degree of not less than 20% and a molecular weight of 500 to 4,000,
a bisphenol type epoxy resin (B) having a molecular weight of 500 to 2,000, and
a bisphenol type liquid epoxy resin (C) having a molecular weight of not more than 500,
as component (b)
an imidazole compound (D) curable at a high temperature not lower than about 150°C and having a melting point of not less than 130°C and
an imidazole compound (E) curable at a relatively low temperature range of from 60°C to 120°C,
as component (c)
glycidyl acrylate or glycidyl methacrylate (F) and
hydroxyethyl acrylate, hydroxyethyl methacrylate or triethylene glycol dimethacrylate (G), and
as compound (d)
a photopolymerization initiator.

11. The process according to Claim 1, wherein the insulating adhesive comprises as essential components the following components:
(e) a brominated bisphenol type epoxy resin or brominated phenoxy resin both having a weight average molecular weight of at least 10,000,
(f) a bisphenol type epoxy resin having an epoxy eqmivalent of not more than 500, and
(g) an epoxy resin caring agent.

12. The process according to Claim 11, wherein the amount of the component (e) is 55 to 90% by weight based on the total weight of the component (e) and the component (f).

13. The process according to Claim 11, wherein the component (g) is an imidazole compound curable at a high temperature not lower than about 150°C and having a melting point of not less than 130°C.

14. The process according to Claim 13, wherein the imidazole compound is at least one compound selected from the group consisting of 2-methylimidazole, 2-phenylimidazole, 2-phenyl-4-methylimidazole, bis (2-ethyl-4-methylimidazole), 2-phenyl-4-methyl-5-hydroxymethylimidazole, 2-phenyl-4,5-dihydroxymethylimidazole and triazine-addition type imidazole.

15. The process according to Claim 11, wherein the component (g) is at least one compound selected from the group consisting of methyltetrahydrophthalic anhydride, methylendomethylene tetrahydrophthalic anhydride, methylbutenyltetrahydrophthalic anhydride, hexahydrophthalic anhydride and methylhexahydrophthalic anhydride.

16. The process according to Claim 11, wherein the component (e) is a brominated bisphenol type epoxy resin or brominated phenoxy resin both having an average molecular weight of at least 10,000 and a bromination degree of not less than 20%, which brominated bisphenol type epoxy resin has a repeating structure wherein brominated bisphenol portion and unbrominated bisphenol portion are alternately arranged.

17. The process according to Claim 1, wherein the insulating adhesive is coated on the copper foil.

18. The process according to Claim 1, wherein the undercoating agent is composed of:
(a) a normally solid epoxy resin having a softening point of not less than 45°C but not more than 120°C,
(b) an epoxy resin curing agent,
(c) a diluent in which the epoxy resin is dissolved and which consists of a photopolymerizable monomer, and
(d) a photopolymerization initiator,
and the insulating adhesive is composed of:
(e) a brominated bisphenol type epoxy resin or brominated phenoxy resin, both having a weight average molecular weight of at least 10,000,
(f) a bisphenol type epoxy resin having an epoxy equivalent of not more than 500, and
(g) an epoxy resin curing agent.

19. The process according to Claim 18, wherein the undercoating agent is composed of
as component (a)
a brominated novolak type epoxy resin (A) having a bromination degree of not less than 20% and a molecular weight of 500 to 4,000,
a bisphenol type epoxy resin (B) having a molecular weight of 500 to 2,000, and
a bisphenol type liquid epoxy resin (C) having a molecular weight of not more than 500,
as compound (b)
an imidazole compound (D) curable at a high temperature not lower than about 150°C and having a melting point of not less than 130°C, and
an imidazole compound (E) curable at a relatively low temperature range of from 60°C to 120°C,
as compound (c)
glycidyl acrylate or glycidyl methacrylate (F) and
hydroxyethyl acrylate; hydroxyethyl methacrylate or triethylene glycol dimethacrylate (G), and
as compound (d)
a photopolymerization initiator.

## Patentansprüche

1. Verfahren zur Herstellung einer Mehrschicht-Leiterplatte (7), umfassend
Beschichten einer Leiterplatten-Innenschicht (1) mit einem licht- und hitzehärtbaren Grundbeschichtungsmittel (3), wobei das Grundbeschichtungsmittel ein Verdünnungsmittel umfasst, in dem ein Epoxidharz gelöst ist und wobei das Verdünnungsmittel aus einem photopolymerisierbaren Monomer besteht,
Bestrahlen des Grundbeschichtungsmittels (3) mit Licht, um es klebfrei zu machen,
Laminieren einer mit einem hitzehärtenden isolierenden Kleber (4) beschichteten Kupferfolie (5) auf die klebfreie Grundbeschichtung, wobei der Kleber (4) als Hauptkomponente ein bromiertes Bisphenol-Epoxidharz oder ein bromiertes Phenoxyharz umfasst, die beide ein Gewichtsmittel des Molekulargewichts von mindestens 10.000 aufweisen, das mit einem Bisphenol-Epoxidharz mit einem Epoxidäquivalent von nicht mehr als 500 gemischt wird, und anschließend
Erhitzen der erhaltenen Anordnung, um die Anordnung vollständig auszuhärten.

2. Verfahren nach Anspruch 1, wobei das Grundbeschichtungsmittel als wesentliche Komponenten die nachstehenden Komponenten (a), (b), (c) und (d) umfasst:
(a) ein normalerweise festes Epoxidharz mit einem Erweichungspunkt von nicht weniger als 45°C, aber nicht mehr als 120°C,
(b) ein Epoxidharz-Härtemittel,
(c) ein Verdünnungsmittel, in dem das Epoxidharz gelöst ist und das aus einem photopolymerisierbaren Monomer besteht, und
(d) einen Photopolymerisationsstarter.

3. Verfahren nach Anspruch 2, wobei Komponente (a) ein Epoxidharz ist, das als Hauptkomponente ein bromiertes Novolak-Epoxidharz mit einem Bromierungsgrad von nicht weniger als 20% und einem Molekulargewicht von 500 bis 4000 umfasst.

4. Verfahren nach Anspruch 2, wobei Komponente (a) ein Gemisch aus einem bromierten Novolak-Epoxidharz mit einem Bromierungsgrad von nicht weniger als 20% und einem Molekulargewicht von 500 bis 4000, einem Bisphenol-Epoxidharz mit einem Molekulargewicht von 500 bis 2000 und einem flüssigen Bisphenol-Epoxidharz mit einem Molekulargewicht von nicht mehr als 500 ist.

5. Verfahren nach Anspruch 2, wobei Komponente (b) eine Imidazolverbindung ist, die bei einer hohen Temperatur von nicht weniger ais 150°C härtbar ist und einen Schmelzpunkt von nicht weniger als 130°C aufweist.

6. Verfahren nach Anspruch 5, wobei die Imidazolverbindung ausgewählt ist aus der Gruppe bestehend aus 2-Methylimidazol, 2-Phenylimidazol, 2-Phenyl-4-methylimidazol, Bis(2-ethyl-4-methylimidazol), 2-Phenyl-4-methyl-5-hydroxymethylimidazol, 2-Phenyl-4,5-dihydroxymethylimidazol und Triazin-Additionstyp-Imidazol.

7. Verfahren nach Anspruch 2, wobei Komponente (b) ein Gemisch aus einer Imidazolverbindung, die bei einer hohen Temperatur von nicht weniger als etwa 150°C härtbar ist und einen Schmelzpunkt von nicht weniger als 130°C aufweist und einer Imidazolverbindung ist, die in einem relativ niedrigen Temperaturbereich von 60°C bis 120°C härtbar ist.

8. Verfahren nach Anspruch 7, wobei die bei niedriger Temperatur härtbare Imidazolverbindung ausgewählt ist aus der Gruppe bestehend aus Imidazol, 2-Ethyl-4-methylimidazol, 2-Undecylimidazol, 1-Cyanoethyl-2-methylimidazol, 1-Cyanoethyl-2-phenylimidazol, 1-Cyanoethyl-2-ethyl-4-methylimidazol, 1-Aminoethyl-2-methylimidazol, 1-(Cyanoethylaminoethyl)-2-methylimidazol und 1-Cyanoethyl-2-phenyl-4,5-bis-(cyanoethoxymethyl)-imidazol.

9. Verfahren nach Anspruch 2, wobei Komponente (c) mindestens eine Verbindung ist, ausgewählt aus der Gruppe bestehend aus Glycidylacrylat, Glycidylmethacrylat, Hydroxyethylacrylat, Hydroxyethylmethacrylat und Triethylenglykoldimethacrylat.

10. Verfahren nach Anspruch 2, wobei das Grundbeschichtungsmittel als Komponente (a) ein bromiertes Novolak-Epoxidharz (A) mit einem Bromierungsgrad von nicht weniger als 20% und einem Molekulargewicht von 500 bis 4000,
ein Bisphenol-Epoxidharz (B) mit einem Molekulargewicht von 500 bis 2000 und ein flüssiges Bisphenol-Epoxidharz (C) mit einem Molekulargewicht von nicht mehr als 500,
als Komponente (b)
eine Imidazolverbindung (D), die bei einer hohen Temperatur von nicht weniger als etwa 150°C härtbar ist und einen Schmelzpunkt von nicht weniger als 130°C aufweist, und eine Imidazolverbindung (E), die in einem relativ niedrigen Temperaturbereich von 60°C bis 120°C härtbar ist,
als Komponente (c)
Glycidylacrylat oder Glycidylmethacrylat (F) und
Hydroxyethylacrylat, Hydroxyethylmethacrylat oder Triethylenglykoidimethacrylat (G), und
als Komponente (d)
einen Photopolymerisationsstarter umfasst.

11. Verfahren nach Anspruch 1, wobei der isolierende Kleber als wesentliche Komponenten umfasst:
(e) ein bromiertes Bisphenol-Epoxidharz oder ein bromiertes Phenoxyharz, die beide ein Gewichtsmittel des Molekulargewichts von mindestens 10.000 aufweisen,
(f) ein Bisphenol-Epoxidharz mit einem Epoxidäquivalent von nicht mehr als 500 und
(g) ein Epoxidharz-Härtemittel.

12. Verfahren nach Anspruch 11, wobei die Menge der Komponente (e) 55 bis 90 Gew.-% beträgt, basierend auf dem Gesamtgewicht der Komponenten (e) und (f).

13. Verfahren nach Anspruch 11, wobei Komponente (g) eine Imidazolverbindung ist, die bei einer hohen Temperatur von nicht weniger als etwa 150°C härtbar ist und einen Schmelzpunkt von nicht weniger als 130°C aufweist.

14. Verfahren nach Anspruch 13, wobei die Imidazolverbindung mindestens eine Verbindung ist, ausgewählt aus der Gruppe bestehend aus 2-Methylimidazol, 2-Phenylimidazol, 2-Phenyl-4-methylimidazol, Bis-(2-ethyl-4-methylimidazol), 2-Phenyl-4-methyl-5-hydroxymethylimidazol, 2-Phenyl-4,5-dihydroxymethylimidazol und Triazin-Additionstyp-lmidazol.

15. Verfahren nach Anspruch 11, wobei Komponente (g) mindestens eine Verbindung ist, ausgewählt aus der Gruppe bestehend aus Methyltetrahydrophthalsäureanhydrid, Methylendomethylentetrahydrophthalsäureanhydrid, Methylbutenyltetrahydrophthalsäureanhydrid, Hexahydrophthalsäureanhydrid und Methylhexahydrophthalsäureanhydrid.

16. Verfahren nach Anspruch 11, wobei Komponente (e) ein bromiertes Bisphenol-Epoxidharz oder ein bromiertes Phenoxyharz ist, die beide ein durchschnittliches Molekulargewicht von mindestens 10.000 und einen Bromierungsgrad von nicht weniger als 20% aufweisen, wobei das bromierte Bisphenol-Epoxidharz eine Wiederholungsstruktur aufweist, in der bromierte Bisphenolabschnitte und nicht-bromierte Bisphenolabschnitte abwechselnd angeordnet sind.

17. Verfahren nach Anspruch 1, wobei die Kupferfolie mit dem isolierenden Kleber beschichtet wird.

18. Verfahren nach Anspruch 1, wobei das Grundbeschichtungsmittel zusammengesetzt ist aus:
(a) einem normalerweise festen Epoxidharz mit einem Erweichungspunkt von nicht weniger als 45°C, aber nicht mehr als 120°C,
(b) einem Epoxidharz-Härtemittel,
(c) einem Verdünnungsmittel, in dem das Epoxidharz gelöst ist und das aus einem photopolymerisierbaren Monomer besteht, und
(d) einem Photopolymerisationsstarter, wobei der isolierende Kleber zusammengesetzt ist aus:
(e) einem bromierten Bisphenol-Epoxidharz oder einem bromierten Phenoxyharz, die beide ein Gewichtsmittel des Molekulargewichts von mindestens 10.000 aufweisen,
(f) einem Bisphenol-Epoxidharz mit einem Epoxidäquivalent von nicht mehr als 500 und
(g) einem Epoxidharz-Härtemittel.

19. Verfahren nach Anspruch 18, wobei das Grundbeschichtungsmittel zusammengesetzt ist aus:
als Komponente (a)
einem bromierten Novolak-Epoxidharz (A) mit einem Bromierungsgrad von nicht weniger als 20% und einem Molekulargewicht von 500 bis 4000,
einem Bisphenol-Epoxidharz (B) mit einem Molekulargewicht von 500 bis 2000 und
einem flüssigen Bisphenol-Epoxidharz (C) mit einem Molekulargewicht von nicht mehr als 500,
als Komponente (b)
einer Imidazolverbindung (D), die bei einer hohen Temperatur von nicht weniger als etwa 150°C härtbar ist und einen Schmelzpunkt von nicht weniger als 130°C aufweist, und einer Imidazolverbindung (E), die in einem relativ niedrigen Temperaturbereich von 60°C bis 120°C härtbar ist,
als Komponente (c)
Glycidylacrylat oder Glycidylmethacrylat (F) und Hydroxyethylacrylat, Hydroxyethylmethacrylat oder Triethylenglykoldimethacrylat (G) und
als Komponente (d)
einen Photopolymerisationsstarter.

## Revendications

1. Procédé de production d'une plaquette de circuit imprimé multicouche (7), comprenant les étapes consistant à revêtir une plaquette de circuit à couche interne (1) avec un agent de couche de base susceptible d'être réticulé sous l'action de la lumière et de la chaleur (3), ledit agent de couche de base comprenant un diluant dans lequel est dissoute une résine époxy, ce diluant étant constitué d'un monomère photopolymérisable, à in-adier l'agent de couche de base (3) avec de la lumière pour la rendre non adhésive, à stratifier sur la couche de base non adhésive une feuille de cuivre (5) enduite d'un adhésif isolant thermodurcissable (4) comprenant. comme principal constituant, une résine époxy de type bisphénol bromée ou une résine phénoxy bromée, toutes deux ayant une masse moléculaire moyenne en poids d'au moins 10 000, qui est mélangée avec une résine époxy de type bisphénol ayant un équivalent époxy non supérieur à 500. puis à chauffer l'assemblage résultant pour cuire intégralement l'assemblage.

2. Procédé selon la revendication 1, dans lequel l'agent de couche de base comprend, comme constituants essentiels, les constituants (a), (b), (c) et (d) suivants:
(a) une résine époxy normalement solide ayant un point de ramollissement non inférieur à 45°C, mais non supérieur à 120°C,
(b) un agent durcisseur de résine époxy,
(c) un diluant dans lequel la résine époxy est dissoute et qui se compose d'un monomère photopolymérisable, et
(d) un amorceur de photopolymérisation.

3. Procédé selon la revendication 2, dans lequel le constituant (a) est une résine époxy comprenant, comme constituant principal, une résine époxy de type novolaque bromée ayant un degré de bromation non inférieur à 20% et une masse moléculaire de 500 à 4 000.

4. Procédé selon la revendication 2, dans lequel le constituant (a) est un mélange d'une résine époxy de type novolaque bromée ayant un degré de bromation non inférieur à 20% et une masse moléculaire de 500 à 4 000, d'une résine époxy de type bisphénol ayant une masse moléculaire de 500 à 2 000 et d'une résine époxy liquide de type bisphénol ayant une masse moléculaire non supérieure à 500.

5. Procédé selon la revendication 2, dans lequel le constituant (b) est un composé imidazole susceptible de durcir à une température élevée, non inférieure à environ 150°C, et ayant un point de fusion non inférieur à 130°C.

6. Procédé selon la revendication 5, dans lequel le composé imidazole est choisi dans le groupe constitué par le 2-méthylimidazole le 2-phénylimidazole, le 2-phényl-4-méthylimidazole, le bis(2-éthyl-4-méthylimidazole), le 2-phényl-4-méthyl-5-hydroxyméthylimidazole. le 2-phényl-4,5-dihydroxyméthylimidazole et les imidazoles de type composé d'addition sur la triazine.

7. Procédé selon la revendication 2, dans lequel le constituant (b) est un mélange d'un composé imidazole susceptible de durcir à une température élevée, non inférieure à environ 150°C, et ayant un point de fusion non inférieur à 130°C, et d'un composé imidazole susceptible de durcir à une température relativement basse, dans la gamme de 60°C à 120°C.

8. Procédé selon la revendication 7, dans lequel le composé imidazole susceptible de durcir à une température basse est choisi dans le groupe constitué par l'imidazole, le 2-éthyl-4-méthylimidazole, le 2-undécylimidazole, le 1-cyanoéthyl-2-méthylimidazole, le 1-cyanoéthyl-2-phénylimidazole, le 1-cyanoéthyl-2-éthyl-4-méthylimidazole, le 1-aminoéthyl-2-méthylimidazole, le 1-(cyanoéthylaminoéthyl)-2-méthylimidazole et le 1-cyanoéthyl-2-phényl-4,5-bis(cyanoéthoxyméthyl)imidazole.

9. Procédé selon la revendication 2, dans lequel le constituant (c) est un élément du groupe constitué par l'acrylate de glycidyle, le méthacrylate de glycidyle, l'acrylate d'hydroxyéthyle, le méthacrylate d'hydroxyéthyle et le diméthacrylate de triéthylèneglycol.

10. Procédé selon la revendication 2, dans lequel l'agent de couche de base comprend:
en tant que constituant (a)
une résine époxy de type novolaque bromée (A) ayant un degré de bromation non inférieur à 20% et une masse moléculaire de 500 à 4 000,
une résine époxy de type bisphénol (B) ayant une masse moléculaire de 500 à 2 000, et
une résine époxy liquide de type bisphénol (C) ayant une masse moléculaire ne dépassant pas 500,
en tant que constituant (b)
un composé imidazole (D) susceptible de durcir à une température élevée non inférieure à environ 150°C et ayant un point de fusion non inférieur à 130°C, et
un composé imidazole (E) susceptible de durcir à une température relativement basse dans la gamme de 60°C à 120°C,
en tant que constituant (c)
de l'acrylate de glycidyle ou du méthacrylate de glycidyle (F), et
de l'acrylate d'hydroxyéthyle, du méthacrylate d'hydroxyéthyle ou du diméthacrylate de triéthylèneglycol (G), et
en tant que constituant (d)
un amorceur de photopolymérisation.

11. Procédé selon la revendication 1, dans lequel l'adhésif isolant comprend, comme constituants essentiels, les constituants suivants:
(e) une résine époxy de type bisphénol bromée ou une résine phénoxy bromée, toutes deux ayant une masse moléculaire moyenne en poids d'au moins 10 000,
(f) une résine époxy de type bisphénol ayant un équivalent époxy non supérieur à 500, et
(g) un agent de réticulation de résine époxy.

12. Procédé selon la revendication Il, dans lequel la quantité du constituant (e) est de 55 à 90% en poids, rapportée au poids total du constituant (e) et du constituant (f).

13. Procédé selon la revendication 11, dans lequel le constituant (g) est un composé imidazole susceptible de durcir à une température élevée non inférieure à environ 150°C et ayant un point de fusion non inférieur à 130°C.

14. Procédé selon la revendication 13, dans lequel le composé imidazole est au moins un composé choisi dans le groupe constitué par le 2-méthylimidazole, le 2-phénylimidazole, le 2-phényl-4-méthylimidazole. le bis(2-éthyl-4-méthylimidazole), le 2-phényl-4-méthyl-5-hydroxyméthylimidazole, le 2-phényl-4,5-dihydroxyméthylimidazole et l'imidazole de type addition à la triazine.

15. Procédé selon la revendication 11, dans lequel le constituant (g) est au moins un composé choisi dans le groupe constitué par l'anhydride méthyltétrahydrophtalique, l'anhydride méthylendométhylène-tétrahydrophtalique, l'anhydride méthylbutényltétrahydrophtalique, l'anhydride hexahydrophtalique et l'anhydride méthylhexahydrophtalique.

16. Procédé selon la revendication 11, dans lequel le constituant (e) est une résine époxy de type bisphénol bromée ou une résine phénoxy bromée, toutes deux ayant une masse moléculaire moyenne en poids d'au moins 10 000 et un degré de bromation non inférieur à 20%, ladite résine époxy de type bisphénol bromée ayant une structure récurrente dans laquelle le motif bisphénol bromé et le motif bisphénol non bromé sont disposés en alternance.

17. Procédé selon la revendication 1, dans lequel l'adhésif isolant est appliqué sur la feuille de cuivre.

18. Procédé selon la revendication 1, dans lequel l'agent de couche de base se compose:
(a) d'une résine époxy normalement solide ayant un point de ramollissement non inférieur à 45°C, mais non supérieur à 120°C,
(b) d'un agent durcisseur de résine époxy,
(c) d'un diluant dans lequel la résine époxy est dissoute et qui se compose d'un monomère photopolymérisable, et
(d) d'un amorceur de photopolymérisation,
et l'adhésif isolant se compose:
(e) d'une résine époxy de type bisphénol bromée ou d'une résine phénoxy bromée, toutes deux ayant une masse moléculaire moyenne en poids d'au moins 10 000.
(f) d'une résine époxy de type bisphénol ayant un équivalent époxy non supérieur à 500, et
(g) d'un agent de réticulation de résine époxy.

19. Procédé selon la revendication 18, dans lequel l'agent de couche de base se compose de:
en tant que constituant (a)
une résine époxy de type novolaque bromée (A) ayant un degré de bromation non inférieur à 20% et une masse moléculaire de 500 à 4 000.
une résine époxy de type bisphénol (B) ayant une masse moléculaire de 500 à 2 000, et
une résine époxy liquide de type bisphénol (C) ayant une masse moléculaire ne dépassant pas 500,
en tant que constituant (b)
un composé imidazole (D) susceptible de durcir à une température élevée non inférieure à environ 150°C et ayant un point de fusion non inférieur à 130°C, et
un composé imidazole (E) susceptible de durcir à une température relativement basse dans la gamme de 60°C à 120°C,
en tant que constituant (c)
de l'acrylate de glycidyle ou du méthacrylate de glycidyle (F), et
de l'acrylate d'hydroxyéthyle, du méthacrylate d'hydroxyéthyle ou du diméthacrylate de triéthylèneglycol (G), et en tant que constituant (d)
un amorceur de photopolymérisation.
